# FASCICULE DE BREVET EUROPEEN

(11) **EP 4 391 746 B1**
(45) Date de publication et mention de la délivrance du brevet: **15.10.2025**
(21) Numéro de dépôt: 23215605.9
(22) Date de dépôt: 11.12.2023
(51) Int. Cl.: H05K 7/02

(54) **BOITIER ELECTRONIQUE COMPRENANT DES CARTES ELECTRONIQUES**
ELEKTRONISCHES GEHÄUSE MIT ELEKTRONISCHEN KARTEN
ELECTRONIC PACKAGE INCLUDING ELECTRONIC CARDS

(30) Priorité: 20.12.2022 FR 2213996
(43) Date de publication de la demande: 26.06.2024
(73) Titulaire: SAGEMCOM BROADBAND SAS, 92270 Bois-Colombes (FR)
(72) Inventeur: MAURECH, Cécile, 92270 Bois-Colombes (FR); HARDY, Mikaël, 92270 Bois-Colombes (FR); JAULIN, Jean-Philippe, 92270 Bois-Colombes (FR)
(74) Mandataire: Cabinet Boettcher

(56) Documents cités:
- JP-U- S6 133 482
- US-A1- 2003 081 377
- US-A1- 2008 285 224
- US-A1- 2013 028 152
- US-A1- 2022 312 652

## Description

L'invention concerne un boitier électronique pour cartes électroniques.

### ARRIERE PLAN TECHNIQUE

Les produits électroniques complexes, tels que les passerelles Internet, notamment de dernière génération, comportent de nombreux composants énergivores puisque devant proposer des performances radiofréquence élevées notamment pour atteindre une sensibilité satisfaisante.

Dans un contexte thermique, il est ainsi connu, pour évacuer les calories de ces composants consommateurs d'énergie électrique, de mettre en œuvre des dissipateurs généralement constitués d'une semelle parallèle à la carte électronique portant les composant à refroidir, des ailettes s'étendant à partir de la semelle pour assurer une évacuation de la chaleur par convection.

Malheureusement les différents composants sont généralement portés par la même carte ou par plusieurs cartes électroniques qui sont alors portées par un dissipateur commun. Ceci impose, lors de la réparation, de nombreuses opérations complexes pour séparer puis réassembler les différents morceaux de la passerelle Internet, ce qui est contraire aux besoins de réparabilité et de réutilisation des parties fonctionnelles.

Les documents US 2013/028152 A1 et US 2008/285224 A1 décrivent l'un un point d'accès à un réseau sans-fil et l'autre, un dispositif de traitement de données de l'art antérieur. D'autres exemples sont décrits dans les documents JP S61 33482 U et US 2022/312652 A1.

### OBJET

Un but de l'invention est donc de proposer un boitier électronique plus modulaire.

### RESUME

En vue de la réalisation de cet objet, on propose un boitier électronique comprenant un caisson comportant au moins une première partie et au moins une deuxième partie, chaque partie formant un réceptacle distinct de sorte qu'une première carte électronique soit logée dans la première partie et de sorte qu'une deuxième carte électronique soit logée dans la deuxième partie, les deux parties étant solidarisées l'une à l'autre par au moins un conduit conformé pour former au moins partiellement un canal de circulation d'air entre les deux parties du caisson, le boitier comprenant au moins un premier connecteur lié à la première carte électronique et au moins un deuxième connecteur lié à la deuxième électronique, les deux connecteurs étant en contact l'un l'autre à travers le conduit, au moins une zone du premier connecteur en contact avec le deuxième connecteur étant dans un matériau électriquement conducteur et au moins une zone du deuxième connecteur en contact avec le premier connecteur étant dans un matériau électriquement conducteur, l'extérieur du conduit étant par ailleurs conformé pour définir au moins partiellement un canal de circulation d'air entre les deux parties du caisson, le boitier comprenant au moins un dissipateur thermique associé à une des deux cartes électroniques, le dissipateur thermique portant le connecteur de la partie correspondante.

De la sorte, les deux parties du caisson permettent de séparer les cartes électroniques associées à chacune des parties et ainsi de rendre le boîtier électronique plus aisément modulaire.

On note que les cartes électroniques peuvent avantageusement demeurer à équipotentialité grâce aux contacts de leurs connecteurs.

Astucieusement, le conduit permet tout à la fois d'autoriser cette équipotentialité et de favoriser le refroidissement des deux parties de caisson. Ce refroidissement est avantageusement naturel grâce à la circulation de l'air entre les deux parties du caisson.

Les deux parties du caisson peuvent ainsi comporter des cartes électroniques aux fonctionnalités distinctes et qui peuvent évoluer de manière indépendante l'une à l'autre.

On propose de plus un boitier tel que précédemment décrit, dans lequel le canal s'étend le long d'une première face de la première partie et le long d'une deuxième face de la deuxième partie, les deux parties étant en regard l'une de l'autre.

On propose de plus un boitier tel que précédemment décrit, dans lequel la première face et la deuxième face sont sensiblement parallèles entre elles.

On propose de plus un boitier tel que précédemment décrit, dans lequel au moins l'une des deux cartes électroniques s'étend sensiblement parallèlement à la première face et/ou à la deuxième face.

On propose de plus un boitier tel que précédemment décrit, dans lequel le canal est fermé mis à part à ses extrémités axiales.

On propose de plus un boitier tel que précédemment décrit, dans lequel le conduit est formé par deux tronçons de conduits comportant des moyens de raccordement d'un tronçon à l'autre.

On propose de plus un boitier tel que précédemment décrit, dans lequel le connecteur est une ailette du dissipateur. On propose de plus un boitier tel que précédemment décrit, comprenant au moins un organe de connexion associé à une des deux cartes électroniques, l'organe de connexion portant le connecteur de la partie correspondante.

On propose de plus un boitier tel que précédemment décrit, dans lequel au moins un connecteur est conformé en une patte. On propose de plus un boitier tel que précédemment décrit, dans lequel au moins un des connecteurs est au moins en partie élastiquement déformable.

On propose de plus un boitier tel que précédemment décrit, dans lequel un des connecteurs est en contact avec un côté latéral de l'autre connecteur.

On propose de plus un boitier tel que précédemment décrit, dans lequel les deux connecteurs sont fixés temporairement l'un à l'autre.

On propose de plus un boitier tel que précédemment décrit, dans lequel au moins un des connecteurs s'étend sur toute la largeur du conduit associé.

On propose de plus un boitier tel que précédemment décrit, dans lequel le boitier est une passerelle Internet.

On propose de plus un boitier tel que précédemment décrit, dans lequel le boitier est un dispositif d'extension de réseau sans-fil.

D'autres caractéristiques et avantages ressortiront à la lecture de la description qui suit de modes de réalisation particuliers non limitatif.

### BREVE DESCRIPTION DES DESSINS

La description de modes de réalisation particuliers fait référence aux dessins annexés, parmi lesquels :
[Fig. 1] la figure 1 est une vue en perspective d'un boitier électronique selon un premier mode de réalisation particulier,
[Fig. 2] la figure 2 est une vue en coupe transversale du boitier illustré à la figure 1,
[Fig. 3] la figure 3 est une vue en perspective d'une portion d'une des parties du boitier illustré à la figure 1,
[Fig. 4] la figure 4 illustre une première variante du boitier illustré à la figure 1,
[Fig. 5] la figure 5 illustre une deuxième variante du boitier illustré à la figure 1,
[Fig. 6] la figure 6 illustre une troisième variante du boitier illustré à la figure 1,
[Fig. 7] la figure 7 illustre une quatrième variante du boitier illustré à la figure 1,
[Fig. 8] la figure 8 est une vue schématique en coupe transversale d'un boitier électronique selon un deuxième mode de réalisation particulier,
[Fig. 9a] la figure 9a est une vue en perspective d'un boitier électronique selon un troisième mode de réalisation particulier,
[Fig. 9b] la figure 9b est une vue en perspective d'une partie du boitier électronique représenté à la figure 9a,
[Fig. 9c] la figure 9c est une vue en perspective d'une autre partie du boitier électronique représenté à la figure 9a.

### DESCRIPTION DETAILLEE

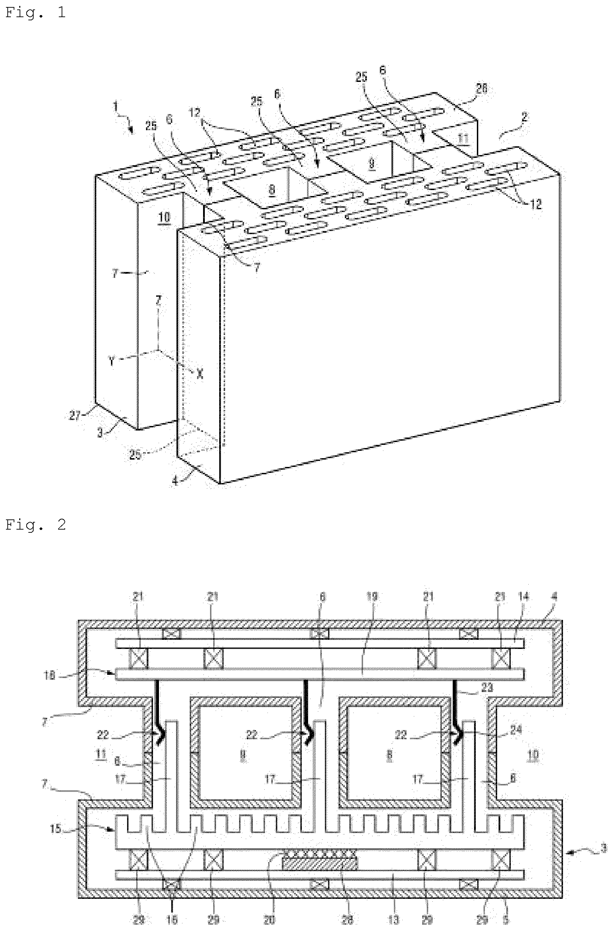

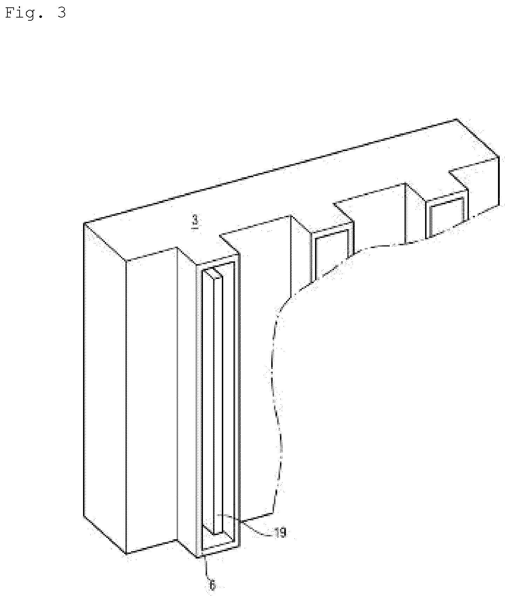

En référence aux figures 1 à 3, il est décrit un boitier 1 électronique selon un premier mode de réalisation particulier.

Le boitier 1 comprend un caisson 2 qui comporte au moins une première partie 3 et une deuxième partie 4.

La première partie 3 et la deuxième partie 4 forment ici conjointement le caisson 2.

De préférence, le boitier 1 est un dispositif électronique proposant au moins deux fonctionnalités distinctes (par exemple une première fonctionnalité de routage de paquets de données et/ou d'accès à un réseau étendu, et une deuxième fonctionnalité de communication sans-fil) pouvant être opérées chacune par un sous-module du boitier 1 (un premier sous-module étant formé par la première partie 3 et un deuxième sous-modulé étant formé par la deuxième partie 4) dudit boitier 1.

Le boitier 1 est par exemple une passerelle Internet (« residential gateway » en anglais) ou un dispositif d'extension de réseau sans-fil (« extender » en anglais). Le caisson 2 est de préférence au moins en partie dans un matériau électriquement isolant. Ce matériau peut en outre contribuer à la dissipation de calories. Par exemple ses deux parties 3, 4 sont dans un matériau électriquement isolant.

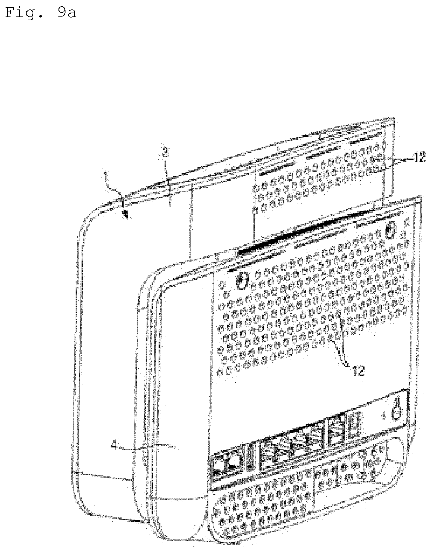

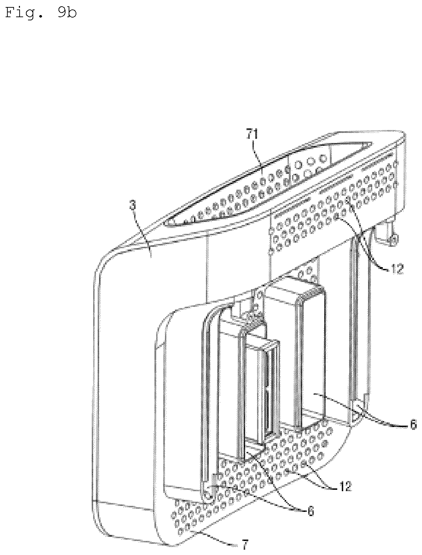

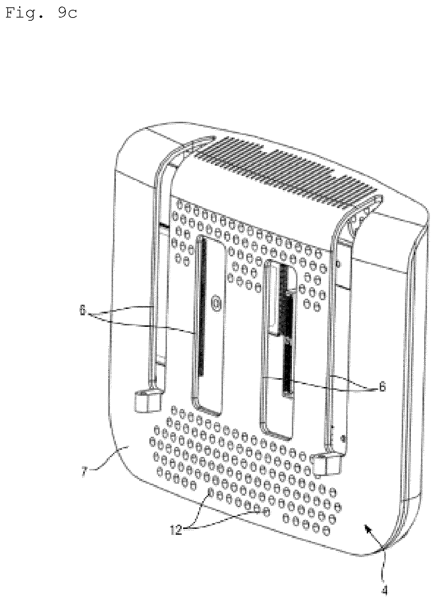

Dans cet exemple non limitatif, les deux parties 3, 4 sont ici identiques, la description qui suit de la première partie 3 s'applique donc également à la deuxième partie 4. *Dans d'autres exemples, les deux parties 3, 4 ne sont pas identiques comme illustrés ci-dessous par les* *figures 9a**,* *9b**,* *9c**.*

La première partie 3 comporte une platine 5. La platine 5 est ici fermée et creuse. La platine 5 forme ainsi un réceptacle fermé.

La première partie 3 comporte par ailleurs au moins un tronçon de conduit 6 et par exemple au moins deux tronçons de conduits 6 et par exemple au moins trois tronçons de conduits 6. Les tronçons de conduits 6 sont tous creux de sorte à être débouchant à chacune de leurs extrémités axiales. Au moins un tronçon de conduits 6 s'étend de sorte à déboucher à sa première extrémité axiale à l'intérieur de la platine 5, sa deuxième extrémité axiale étant par ailleurs libre.

La première partie 3 est donc creuse.

Au moins un tronçon de conduit 6 s'étend à partir de la platine 5 vers l'extérieur de la première partie 3 (en direction de la deuxième partie 4 lorsque les deux parties 3, 4 sont solidarisées entre elles). Au moins un tronçon de conduit 6 s'étend à partir d'une face de jonction 7 de la platine 5 (soit une face de la première partie 3 tournée vers la deuxième partie 4 lorsque les deux parties 3, 4 sont solidarisées entre elles) . De préférence, la face de jonction 7 est plane et s'étend dans un plan normal à un premier axe X, le plan étant ainsi défini par un deuxième axe Y et un troisième axe tous deux perpendiculaires au premier axe X, le troisième axe Z étant par ailleurs perpendiculaire au deuxième axe Y.

Au moins un tronçon de conduit 6 s'étend rectilignement selon le premier axe X vers l'extérieur de la première partie 3 (en direction de la deuxième partie 4 lorsque les deux parties 3, 4 sont solidarisées entre elles).

De préférence, les différents tronçons de conduits 6 s'étendent tous à partir de la même face de la platine 5 et de préférence encore de la même face de jonction 7 de la platine 5. De préférence, les différents tronçons de conduits 6 sont identiques entre eux. De préférence encore, les différents tronçons de conduits 6 s'étendent parallèlement entre eux au premier axe X.

La section transversale d'au moins l'un des tronçons de conduits 6 (selon un plan de section de normale le troisième axe Z) est d'une forme quelconque et par exemple rectangulaire, carré ...

Dans le cas présent, au moins un tronçon de conduit 6 s'étend également rectilignement selon le troisième axe Z le long de la face de jonction 7. Au moins un tronçon de conduit 6 s'étend ici longitudinalement selon le troisième axe Z. Ledit tronçon de conduit 6 s'étend par exemple sur toute une dimension de la face de jonction 7 (dimension de la face de jonction considérée selon le troisième axe Z). Ledit tronçon de conduit 6 est ici agencé de sorte à s'étendre dans la continuité d'une première face 26 de la première partie 3 adjacente à la face de jonction 7 et de sorte à s'étendre dans la continuité d'une deuxième face 27 de la première partie 3 adjacente à la face de jonction 7 et opposée à la première face. Les extrémités longitudinales 25 (selon le troisième axe Z) du tronçon de conduit 6 sont fermées. Le tronçon de conduit 6 forme donc par ses extrémités longitudinales 25 un plan continu avec les faces adjacentes à la face de jonction 7.

Comme déjà indiqué, ses extrémités axiales (selon le premier axe X) sont ouvertes. Le réceptacle formé par la platine 5 ne débouche ainsi sur l'extérieur de la première partie 3 que par l'intermédiaire de ses tronçons de conduits 6 et leurs extrémités axiales.

Optionnellement la première partie 3 et/ou la deuxième partie 4 peut comporter des orifices d'aération 12 (dont une partie seulement est ici référencée) sur une ou plusieurs de ses faces et par exemple sur une ou plusieurs de ses faces autres que sa face de jonction 7. Par exemple des orifices d'aération 12 peuvent être ménagés sur deux faces en regard de la première partie 3 et/ou la deuxième partie 4 pour assurer une circulation d'air à l'intérieur de la partie considérée.

Dans ce cas, chaque réceptacle est fermé mais communique avec l'autre réceptacle via les tronçons de conduits 6 et avec l'extérieur les orifices d'aération 12 associés. Il s'agit donc là de petites ouvertures et non de larges découpages du réceptacle.

La section transversale d'au moins l'un des tronçons de conduits 6 (selon un plan de section de normale le premier axe X) est d'une forme quelconque et par exemple rectangulaire, carré ...

Les tronçons de conduits 6 sont agencés à intervalles réguliers le long de la face de jonction 7 (selon le deuxième axe Y).

Au moins un des tronçons de conduits 6 et de préférence tous les tronçons de conduits 6 sont d'une seule pièce avec la platine 5.

Lorsque la première partie 3 et la deuxième partie 4 sont assemblées, chaque tronçon de conduit 6 de la première partie 3 s'étend de préférence dans le prolongement d'un tronçon de conduit 6 de la deuxième partie 4. De préférence, chaque tronçon de conduit 6 de la première partie 3 s'étend co-axialement au tronçon de conduit 6 en regard de la deuxième partie 4 (et ici co-axialement au premier axe X).

Dès lors, les tronçons de conduits 6 de la première partie 3 et les tronçons de conduits de la deuxième partie 4 dessinent ensemble des conduits généraux reliant la première partie 3 à la deuxième partie 4 et plus précisément la platine 5 de la première partie 3 à la platine 5 de la deuxième partie 4 et plus précisément encore le réceptacle de la première partie 3 au réceptacle de la deuxième partie 4.

Ainsi les deux réceptacles 3, 4 sont fermés vis-à-vis de l'extérieur du caisson 2 mais communiquent entre eux via les conduits.

De préférence, les deux tronçons de conduits 6 sont munis de leurs moyens de coopération de sorte à assurer un encastrement du tronçon de l'une des parties à un tronçon en regard de l'autre des parties (par emboitement, par clipsage ...).

La première partie 3 et la deuxième partie 4 sont ainsi assemblées ensemble de manière amovible.

Un premier conduit 6 ainsi formé par l'assemblage de la première partie 3 et de la deuxième partie 4 dessine avec un second conduit 6 adjacent et les deux faces de jonction 7 les portant, un canal de circulation d'air entre les deux parties 3 et 4. Plus précisément, le boitier 1 représenté aux figures 1 et 2 comporte trois conduits 6 qui définissent deux à deux un premier canal de circulation d'air 8 et un deuxième canal 9 de circulation d'air.

Les canaux 8 et 9 remplisse chacun une fonction de circulation d'air. Lesdits canaux 8, 9 sont ici identiques. La description qui suit du premier canal 8 est donc également applicable ici au deuxième canal 9. Alternativement, les canaux 8 et 9 peuvent ne pas être identiques et ainsi présenter chacun des agencements et/ou des formes différentes et/ou des dimensions différentes.

Le premier canal 8 s'étend longitudinalement parallèlement au troisième axe Z. Le premier canal 8 s'étend rectilignement parallèlement au troisième axe Z. Le premier canal 8 s'étend ainsi parallèlement aux deux faces de jonction 7.

Le premier canal 8 s'étend par ailleurs ici sur toute la largeur desdites deux faces de jonction 7 (largeur considérée selon le troisième axe Z).

Le premier canal 8 forme ainsi une lame d'air entre la première partie 3 et la deuxième partie 4.

Cette lame d'air joue notamment le rôle d'isolation thermique entre la première partie 3 et la deuxième partie 4. La deuxième partie 4 est typiquement mieux préservée des calories dissipées par la première partie 3 grâce à cette lame d'air, et réciproquement.

Cette lame d'air facilite en outre une circulation d'air entre les deux parties 3, 4 selon un effet « cheminée ». En effet, l'air circule dans le canal 8 depuis la première extrémité axiale du caisson 2 vers sa deuxième extrémité axiale opposée. Cette circulation d'air à travers le canal 8 favorise la dissipation de chaleur à la surface des faces de jonction 7 par convection. Ceci permet de bien refroidir les deux faces de jonction 7 et par là les réceptacles associés.

La forme de la section du premier canal 8 (de normale le troisième axe Z) est dépendante des formes des conduits 6 et des formes des faces de jonction 7. La forme de la section du premier canal 8 peut être ainsi quelconque, par exemple carré ou rectangulaire...

Le premier canal 8 n'est par ailleurs débouchant à l'extérieur du caisson 2 qu'au niveau de ses deux extrémités axiales (selon le troisième axe Z).

On note que les conduits définissent par ailleurs sur les côtés du caisson 2 un premier canal 10 (de circulation d'air) d'extrémité et un deuxième canal 11 (de circulation d'air) d'extrémité qui sont eux à demi-ouvert sur l'extérieur au niveau de l'un de leur côté.

Ceci est dû au fait que les canaux 10, 11 d'extrémité ne sont délimités que par un seul conduit 6 et non deux.

Ces canaux 10, 11 d'extrémité participent néanmoins également activement au refroidissement du caisson 2.

Selon un autre aspect, le boitier 1 comporte une première carte électronique 13 agencée dans le premier réceptacle et une deuxième carte électronique 14 agencée dans le deuxième réceptacle.

Le caisson 2 est conformé de sorte que les deux cartes électroniques 13, 14 s'étendent parallèlement entre elles. Le caisson 2 est conformé de sorte qu'au moins l'une des cartes électroniques 13, 14 s'étendent parallèlement à la face de jonction 7 de la partie du caisson 2 associée. Ladite carte électronique 13, 14 présente ainsi deux faces principales s'étendant toutes dans des plans parallèles à celui contenant le deuxième axe Y et le troisième axe Z. Les canaux 8, 9, 10, 11 s'étendent ainsi parallèlement à ladite carte électronique 13, 14.

Par exemple au moins l'une des cartes électroniques 13, 14 est fixée à une ou plusieurs parois internes de la platine 5 associée (par exemple par clipsage, emboitement, vissage, collage, brasage, soudage ...). De préférence, ladite carte électronique 13, 14 est fixée à des parois internes de ladite platine 5 qui ne sont pas celles associées à la face de jonction 7.

De préférence, au moins l'un des cartes électroniques, et par exemple la première carte électronique 13, est associée à au moins un dissipateur 15 thermique.

Le dissipateur 15 comporte de façon connue en soi une semelle présentant une première face principale pourvue d'ailettes 16 (dont une partie seulement est référencée ici) et une deuxième face principale opposée à la première face principale. La deuxième face principale est ici dépourvue d'ailettes et est de préférence lisse.

Les ailettes 16 s'étendent essentiellement perpendiculairement à la première face principale. Les ailettes 16 s'étendent toutes essentiellement parallèlement les unes aux autres. Des agencements différents et/ou des formes différentes et/ou des dimensions différentes et/ou des matériau différents des ailettes 16 sont possibles pour au moins deux ailettes considérées.

Le dissipateur 15 est au moins en partie dans un matériau thermiquement conducteur.

En effet, le dissipateur 15 doit être thermiquement conducteur pour assurer une bonne circulation des calories à évacuer des composants 28 (un seul étant représenté ici) présents sur la première carte électronique 13 associée.

De préférence également, le dissipateur 15 est au moins en partie dans un matériau électriquement conducteur.

En effet, le dissipateur 15 doit être au moins en partie électriquement conducteur pour assurer son équipotentialité électrique au regard des signaux électroniques mis en œuvre dans la première carte électronique 13 associée.

Ces deux caractéristiques de conduction peuvent être natives au matériau choisi pour le dissipateur 15 ou, être la combinaison d'au moins deux matériaux.

Le dissipateur 15 peut, par exemple, être réalisé en ou à base d'aluminium (extrudé, injecté ...), en cuivre ou en tout autre matériau métallique. Il peut aussi, au moins en partie, être à base de ou en matière électriquement isolant (par exemple en ou à base de matière plastique) et être par ailleurs, recouvert au moins en partie, d'une peinture, d'un vernis et/ou tout autre revêtement en matériau électriquement conducteur.

Le dissipateur 15 est relié mécaniquement à la première carte électronique 13 et par exemple fixé à la première carte électronique 13 (par vissage, clipsage, emboitement, brasage, collage, soudage, etc.).

Par ailleurs le dissipateur 15 est relié thermiquement à la première carte électronique 13, et en particulier aux composants 28, par au moins une liaison spécifique. Par exemple la liaison spécifique comporte au moins un bras 20 en matériau thermiquement conducteur est fixé à une première extrémité à la première carte électronique 13 (via l'un des composants 28) et à une deuxième extrémité au dissipateur 15. Ledit bras 20 peut donc également servir de liaison mécanique entre le dissipateur 15 et la première carte électronique 13.

Par ailleurs le dissipateur 15 est relié électriquement à la première carte électronique 13 par au moins une liaison spécifique 29 afin d'assurer une équipotentialité entre le dissipateur 15 et la première carte électronique 13. Ladite liaison 29 peut être commune ou non à la liaison thermique précitée. Le bras 20 peut donc également être utilisé en tant que liaison électrique.

De préférence, le dissipateur 15 est agencé de sorte à s'étendre parallèlement à la première carte électronique 13. Les deux faces principales du dissipateur 15 s'étendent ainsi parallèlement au plan contenant le deuxième axe Y et le troisième axe Z. Dans le cas présent, le dissipateur 15 s'étend ainsi également parallèlement à la face de jonction 7.

De préférence encore, la deuxième face principale du dissipateur 15 est celle tournée vers la première carte électronique 13, la première face principale (celle portant les ailettes 16) étant tournée vers la face de jonction 7. La première carte électronique 13 est agencée au plus proche du fond de la platine 5 de sorte que le dissipateur 15 soit lui-même agencé entre la première carte électronique 13 et le plafond de la platine 5 dans lequel débouchent les tronçons de conduits 6 de la première partie 3.

Lorsque la première carte électronique 13 et le dissipateur 15 sont agencés dans la première partie 3, les ailettes 16 s'étendent parallèlement au premier axe X. Les ailettes 16 s'étendent ainsi rectilignement parallèlement audit premier axe X. Les ailettes 16 s'étendent ainsi en direction de la deuxième partie 4.

Au moins une ailette 16 est d'une longueur telle qu'elle s'étend jusqu'à sensiblement le plafond de la platine. Au moins une ailette, appelée ailette principale 17, présente une longueur plus importante et s'étend ainsi à l'intérieur de l'un des tronçons de conduit 6. De préférence, pour chaque tronçon de conduit 6 de la première partie 3, le dissipateur 15 comporte une ailette principale 17. Les différentes ailettes principales 17 sont toutes identiques dans cet exemple. Dans d'autres exemples elles peuvent être différentes dans leurs formes et/ou leurs agencements et/ou leurs dimensions et/ou leurs matériaux pour au moins deux ailettes principales considérées. Les différentes ailettes principales 17 s'étendent essentiellement parallèlement les unes aux autres dans chacun des tronçons de conduits 6 attribués. Au moins l'une desdites ailettes 17 est d'une longueur telle (selon le premier axe X) qu'elle s'étend au-delà du tronçon de conduit 6 de la première partie 3 de sorte à s'étendre également dans le tronçon de conduit 6 en regard de la deuxième partie 4 lorsque les deux parties 3, 4 sont assemblées. L'extrémité libre de ladite ailette principale 17 s'étend ici dans le tronçon de conduit 6 de la deuxième partie 4.

Les ailettes principales 17 sont ici conformées en plaquette. Chaque ailette principale 17 comporte ainsi deux faces principales qui s'étendent parallèlement à un plan contenant le premier axe X et le troisième axe Z. Chaque ailette principale 17 présente donc une même hauteur (selon le premier axe X) qui est la même sur toute sa longueur (selon le troisième axe Z). Par exemple, chaque ailette principale 17 s'étend ici sensiblement sur toute la longueur (selon le troisième axe Z) du tronçon de conduit 6 associé.

Les ailettes principales 17 jouent avantageusement un rôle supplémentaire en plus de celui d'assurer une dissipation thermique. En effet, lesdites ailettes principales 17 jouent le rôle de connecteur électrique pour la première partie 3 qui vont coopérer avec des connecteurs électriques correspondants de la deuxième carte électronique 14 qui seront décrit plus bas. Le contact par chaque couple de connecteurs assure un couplage électrique entre les deux cartes électroniques 13, 14 et donc une équipotentialité entre lesdites cartes.

Les ailettes principales 17 assurant un contact électrique avec les connecteurs en regard de la deuxième partie 4, les ailettes principales 17 sont de préférence munies au moins en partie d'une surface assurant un contact électrique fiable avec lesdits connecteurs en regard. Ladite surface est par exemple créée en déposant une peinture, un vernis ou tout autre revêtement électriquement conducteur sur au moins une zone de contact de l'ailette principale 17 considérée avec le connecteur en regard.

Optionnellement, la deuxième carte électronique 14 n'est pas associée à un dissipateur thermique.

En revanche, la deuxième carte électronique 14 est ici reliée à un organe de connexion 18.

De préférence, l'organe de connexion 18 comporte une embase 19 agencée de sorte à s'étendre parallèlement à la deuxième carte électronique 14.

L'embase 19 a pour rôle d'assurer une équipotentialité au moins au niveau de la face principale de la deuxième carte électronique 14 en regard de l'organe de connexion 18.

L'embase 19 est au moins en partie dans un matériau électriquement conducteur. Par exemple, l'embase 19 est en ou à base d'aluminium (extrudé, injecté ...) en cuivre, en acier, ou en tout autre matériaux métallique. Elle peut aussi au moins en partie être à base de ou en matière électriquement isolante (par exemple en ou à base de matière plastique) et être par ailleurs, recouverte au moins en partie, d'une peinture, d'un vernis et/ou tout autre revêtement en matériau électriquement conducteur. Typiquement, l'embase 19 est conformée en une plaque. L'embase 19 comporte donc une première face principale et une deuxième face principale opposée à la première face principale.

Les deux faces principales de l'embase 19 s'étendent ainsi parallèlement au plan contenant le deuxième axe Y et le troisième axe Z. Dans le cas présent, l'embase 19 s'étend ainsi également parallèlement à la face de jonction 7.

De préférence encore, la deuxième face principale de l'embase 19 est celle tournée vers la deuxième carte électronique 14, la première face principale étant tournée vers la face de jonction 7.

La deuxième carte électronique 14 est agencée au plus proche du fond de la platine 5 de sorte que l'organe de connexion 18 soit lui-même agencé entre la deuxième carte électronique 14 et le plafond de la platine 5 dans lequel débouchent les tronçons de conduits 6 de la deuxième partie 4.

L'organe de connexion 18 est relié mécaniquement à la deuxième carte électronique et par exemple fixé à la deuxième carte électronique 14 (par clipsage, emboitement, vissage, brasage, collage, soudage, etc.). Eventuellement, l'organe de connexion 18 est en outre relié mécaniquement à une ou plusieurs parois internes de la platine 5 de la deuxième partie 4 et par exemple fixé à la ou auxdites parois internes (par clipsage, emboitement, vissage, brasage, collage, soudage, etc.).

Par ailleurs l'organe de connexion 18 est relié électriquement à la deuxième carte électronique 14 par au moins une liaison spécifique afin d'assurer une équipotentialité entre l'organe de connexion 18 et la deuxième carte électronique 14. Par exemple un bras 21 en matériau électriquement conducteur est fixé à une première extrémité à la deuxième carte électronique 14 et à une deuxième extrémité à l'organe de connexion 18. Ledit bras 21 sert donc ici également à la liaison mécanique de l'organe de connexion à la deuxième carte électronique 14. Optionnellement l'organe de connexion 18 est ici également relié thermiquement à la deuxième carte électronique 14 par au moins une liaison spécifique. Ladite liaison peut être commune ou non à la liaison électrique précitée. Le bras 21 peut donc également être utilisé en tant que liaison thermique. Par ailleurs, l'organe de connexion 18 comporte au moins un des connecteurs 22 précités qui s'étend à partir de l'embase 19 et plus précisément ici à partir de la première face principale de l'embase 19.

Les connecteurs 22 s'étendent ici perpendiculairement à la première face principale. Les connecteurs 22 s'étendent toutes parallèlement les unes aux autres.

Lorsque la deuxième carte électronique 14 et l'organe de connexion 18 sont agencés dans la deuxième partie 4, les connecteurs 22 s'étendent parallèlement au premier axe X. Les connecteurs 22 s'étendent ainsi rectilignement parallèlement audit premier axe X. Les connecteurs 22 s'étendent ainsi en direction de la première partie 3.

De préférence, pour chaque tronçon de conduit 6 de la deuxième partie 4, l'organe de connexion 18 comporte au moins un connecteur 22 s'étendant dans ledit tronçon de conduit 6. Les différents connecteurs 22 sont tous ici identique dans cet exemple. Dans d'autres exemples, les différents connecteurs 22 peuvent être chacun de formes et/ou dimensions différentes et/ou d'agencement différents. Les différents connecteurs 22 s'étendent essentiellement parallèlement les uns aux autres dans chacun des tronçons de conduit 6 attribué. L'extrémité libre d'au moins l'un des connecteurs 22 (et ici de tous les connecteurs 22) s'étend dans le tronçon de conduit 6 de la deuxième partie 4.

L'embase 19 et les connecteurs 22 sont assemblés entre eux - par exemple par rivetage, bouterole, soudage, ou tout autre procédé. Ils peuvent également être d'une seule pièce - travaillée par exemple par pliage, extrusion, emboutissage ou tout autre procédé.

Au moins l'un des connecteurs 22 est conformé en une patte. La patte étant conformée de sorte à comprendre une jambe 23 dont une première extrémité est solidarisée à l'embase 19 et dont une deuxième extrémité est prolongée par un crochet 24. Le crochet 24 et la jambe 23 sont de préférence d'une même pièce.

De préférence, au moins l'un des connecteurs 22 est conformé pour pouvoir se déformer élastiquement relativement à l'embase 19. De préférence, la jambe 23 et/ou le crochet 24 est ainsi conformé pour pouvoir se déformer élastiquement relativement à l'embase 19.

Au moins l'un des connecteurs 22 est au moins en partie en ou à base de métal et de préférence au moins en partie en un ou à base d'un métal suffisamment souple pour permettre une déformation élastique d'au moins une partie dudit connecteur 22. Le connecteur 22 est ainsi au moins en partie en ou à base d'acier, d'inox ...

Au moins l'un des connecteurs 22 est obtenu par pliage ou emboutissage (par exemple d'une lamelle souple), par mise sous pression d'un ressort ...

Lorsque le boitier 1 est assemblé, chaque crochet 24 vient en appui contre l'une des ailettes principales 17 et plus précisément ici en appui contre la surface de l'ailette principale 17 traitée pour assurer une meilleure liaison électrique.

Il y a donc un contact électrique ponctuel entre chaque couple patte/ailette et ainsi un contact électrique entre l'organe de connexion 18 (et par là de la deuxième carte électronique) et le dissipateur 15 (et par là de la première carte électrique 13).

La patte élastiquement déformable des connecteurs 22 permet :
- d'améliorer le contact entre l'ailette principale 17 et la patte, et/ou,
- de compenser un éventuel défaut d'alignement entre l'ailette principale 17 et la patte et/ou entre les deux tronçons d'un même conduit.

On peut avoir une seule patte associée à chaque ailette principale 17 ou bien avoir plusieurs pattes associées à chaque ailette principale 17. Dans ce dernier cas, le groupe de pattes sera tel que les pattes dudit groupe s'étendront séparées les unes des autres dans le tronçon de conduit 6 de la deuxième partie 4 selon le troisième axe Z.

Dans le cas présent, au moins l'une des pattes est en contact avec l'ailette principale 17 associée - sur un côté latéral de ladite ailette 17 (ici une des faces principales de l'ailette principale 17).

Dès lors, la patte a tendance à glisser le long de l'ailette principale 17 lors de la solidarisation des deux parties 3, 4 du caisson 2.

Ceci permet également d'assurer un guidage mécanique entre l'organe de connexion 18 et le dissipateur 15 lors de l'assemblage des deux parties du caisson 2.

Ainsi, en service, lorsque l'on assemble les deux parties 3, 4 du caisson 2 entre elles, on vient dans le même mouvement assurer un contact entre les connecteurs 22 de la première partie 3 (les ailettes principales 17) et ceux de la deuxième partie 4 (les pattes). De la sorte, une équipotentialité est assurée entre les deux parties 3, 4 d'un même boitier 1 et ce de manière relativement simple et aisée.

De façon avantageuse, il existe une séparation physique entre les deux parties 3, 4 (mis à part au niveau de la jonction entre les tronçons de conduits 6) et donc une séparation des propriétés de dissipation thermique de chacune des parties 3, 4.

On note en particulier que le contact entre une ailette principale 17 de la première partie 3 et un connecteur 22 de la deuxième partie 4 est quasi ponctuel. En outre la fonctionnalité d'élasticité du connecteur 22 de la deuxième partie 4 implique l'usage d'un connecteur 22 relativement fin. Dès lors, il en résulte une impédance thermique significative qui freine considérablement la transmission des calories depuis le dissipateur 15 vers l'organe de connexion 18. Ainsi, la transmission de chaleur par conduction depuis les composants de la première carte électronique 13 vers la deuxième carte électronique 14 est très limitée. On peut donc agencer les composants électroniques les plus énergivores sur la première carte électronique 13.

Le boitier 1 ainsi décrit présente une bonne modularité en comprenant des parties 3, 4 facilement séparables, équipotentielles et isolées thermiquement l'une de l'autre. Dès lors le boitier 1 peut renfermer des cartes électroniques aux fonctions différentes. On peut ainsi aisément remplacer une carte électronique par une autre ce qui permet d'assurer une évolution des fonctionnalités dans le boitier 1 sans en changer tous les éléments.

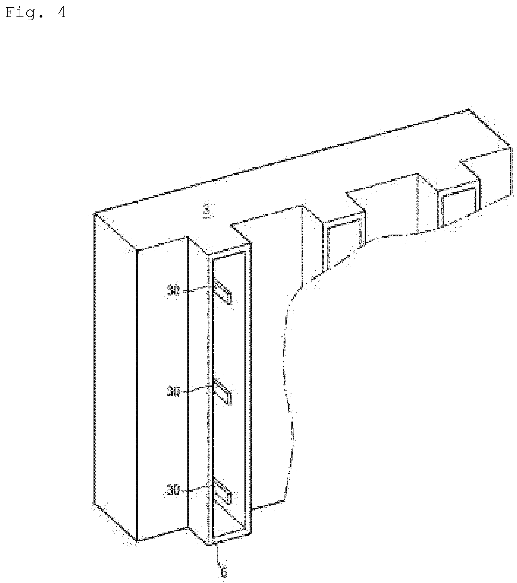

Bien entendu, le boitier 1 peut présenter une autre forme que celle décrite. Par exemple le nombre et/ou la forme des ailettes 16, 17 peut être différent de ce qui a été indiqué. Ainsi au moins une des ailettes principales 17 peut ne pas présenter la même hauteur (selon le premier axe X) sur toute sa longueur (selon le troisième axe Z). Par exemple l'ailette principale 17 peut se déployer jusqu'au point de contact avec la patte en regard seulement au niveau de ladite patte. En référence à la figure 4, l'ailette principale 17 peut ainsi présenter une base (éventuellement confondue avec la semelle du dissipateur 15) à partir de laquelle s'étend au moins un picot 30 dans le tronçon de conduit 6 en regard et par exemple au moins deux picots 30 espacés l'un de l'autre selon le troisième axe Z. Par exemple les au moins deux picots 30 sont identiques entre eux. Par exemple les au moins deux picots 30 s'étendent parallèlement l'un à l'autre et au premier axe X. Par exemple l'un des picots 30 est associé à l'un des connecteurs 22 de la partie en regard.

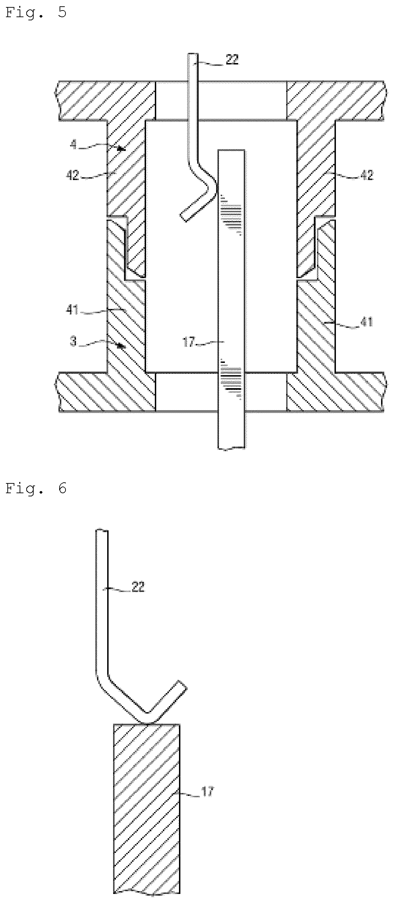

Ainsi, bien qu'ici les extrémités libres des tronçons de conduits 6 de chacune des parties soient planes, lesdites extrémités libres pourront être d'une forme plus complexe. Ainsi une extrémité libre d'un tronçon de conduit 6 de la première partie 3 et une extrémité libre d'un tronçon de conduit 6 de la deuxième partie 4 en regard pourront comporter l'une une portion de raccordement 41 et l'autre une portion de raccordement 42, les deux portions de raccordement 41, 42 venant s'encastrer l'une dans l'autre lors de l'assemblage des deux parties 3, 4 pour fixer les deux parties 3, 4 entre elles. En outre ceci assurera un guidage entre les deux parties 3, 4. Le couple de portions de raccordement 41, 42 est par exemple choisi parmi la liste suivante : tenon/mortaise, cadre/feuillure, pion/trou, nervure/glissière femelle ... Un tel raccordement est par exemple illustré à la figure 5.

Ainsi au moins une des pattes peut être en contact (physique et/ou électrique) avec l'ailette principale 17 associée au niveau d'une autre portion de l'ailette principale 17 que sa face latérale. En référence à la figure 6, la patte peut être en contact (physique et/ou électrique) avec l'ailette 17 principale au niveau de la face supérieure libre de ladite ailette principale 17. La patte ne vient alors pas glisser le long de l'ailette principale 17 lors de l'assemblage des deux parties 3, 4 entre elles mais vient plutôt se rétracter en appui contre ladite ailette. La patte tend ainsi à pousser l'ailette principale 17 vers le dissipateur 15.

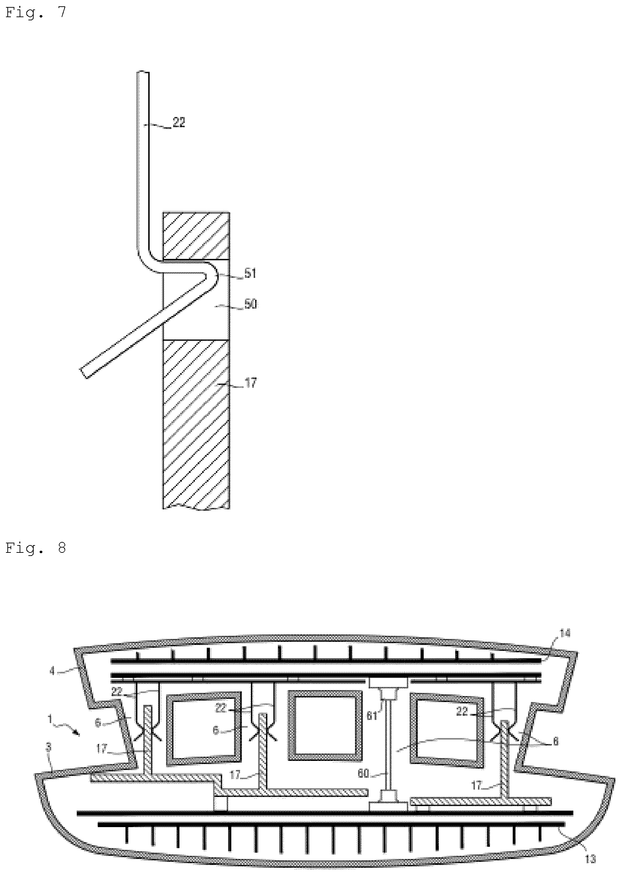

Ainsi au moins l'une des pattes peut ne pas être simplement en contact avec l'ailette principale 17 associée, mais être temporairement solidarisée à ladite ailette 17 (par clipsage, par emboitement ...). Ceci permet par exemple de maintenir la patte en position dans l'ailette principale 17 (ou inversement) et donc assurer un bon contact électrique entre les deux, même en cas de vibration ou de tout autre événement tendant à séparer les deux parties 3, 4 l'une de l'autre. En référence à la figure 7, l'ailette principale 17 comporte par exemple une lumière ou un orifice 50 dans lequel une partie saillante 51 du connecteur 22 associé vient s'encastrer lors de la solidarisation des deux parties 3, 4 entre elles.

Ainsi les deux parties 3, 4 du capot peuvent présenter une autre forme que celle indiquée et être par exemple plus arrondies que ce qui a été décrit. La figure 8 illustre ainsi une autre forme de caisson 2.

Ainsi bien qu'ici il y ait nécessairement au moins un couplage électrique pour l'équipotentialité entre un connecteur lié à la première carte électronique 13 et un connecteur lié à la deuxième carte électronique 14 à travers l'un des conduits, le boitier 1 peut être conformé de sorte qu'aucun couplage n'ait lieu dans au moins l'un des conduits ou de sorte qu'un autre type de couplage qu'un couplage électrique pour l'équipotentialité ait lieu à travers l'un des conduits. La figure 8 propose ainsi qu'à travers l'un des conduits 6 s'effectue un couplage électronique par le raccordement d'au moins un bus 60 lié à la première carte électronique 13 à au moins un bus 61 lié à la deuxième carte électronique 14.

Par exemple l'au moins un bus 60 et l'au moins bus 61 permettent l'échange et la communication de données (données de contrôle et/ou données utiles) entre la première carte électronique 13 et la deuxième carte électronique 14. Cet échange et communication de données est opéré classiquement par un lien de communication par exemple électrique/électronique. Dans ce cas de figure, au moins l'un des autres conduits 6 assurent un couplage d'équipotentialité via la coopération d'une ailette principale 17 et du connecteur 22. Cette équipotentialité obtenue permet par exemple d'assurer un plan de masse équipotentiel des cartes électroniques 13, 14 pour maitriser le bruit électromagnétique parasite qui pourrait être amplifié par des parties laissées flottantes électriquement. Ainsi bien qu'ici les deux parties 3, 4 soient identiques, les deux parties 3, 4 peuvent être différentes. Comme illustré aux figures 9a, 9b et 9c, l'une des parties peut être de plus grandes dimensions et recouvrir au moins en partie l'autre des parties. Le caisson 1 peut ainsi comprendre au moins un conduit général 71 dans lequel débouche plusieurs conduits 6 tels que décrits ci-dessus. Par exemple la partie (la première partie 3 ou la deuxième partie 4) de plus grandes dimensions peut seule former le conduit général 71 dans lequel débouche les conduits secondaires 6 formés par l'assemblage de la première partie 3 et de la deuxième partie 4.

Optionnellement la première partie 3 et/ou la deuxième partie 4 peut également comporter des orifices d'aération 12 (dont une partie seulement est ici référencée) sur une ou plusieurs de ses faces et par exemple sur sa face jonction et/ou sur une ou plusieurs de ses faces autres que sa face de jonction 7.

Bien entendu, l'objet de l'invention n'est pas limité aux modes de réalisation décrits mais englobe toutes variantes entrant dans le champ de l'objet tel que défini par les revendications.

Le boitier pourra comporter un capotage venant recouvrir le caisson pour le masquer au moins en partie. Le capotage pourra être en matière plastique par exemple.

La forme et/ou le nombre de pièces formant le caisson pourra être différent de ce qui a été indiqué. Le caisson pourra ainsi comprendre plus de deux parties et par exemple trois parties.

Le nombre et/ou la forme des conduits pourra être différent de ce qui a été indiqué.

Le nombre et/ou la forme des canaux de circulation d'air pourra être différent de ce qui a été indiqué. Par exemple, le boitier sera conformé de sorte que les deux parties soient espacées l'une de l'autre (selon le premier axe X) d'un écartement de plusieurs millimètres permettant de former une lame d'air suffisante à l'isolation thermique entre les deux parties. Par exemple le boitier sera conformé de sorte que les deux parties soient espacées l'une de l'autre (selon le premier axe X) d'un écartement de 5 à 20 millimètres et par exemple de 10 à 15 millimètres. Ceci est particulièrement avantageux pour une bonne isolation thermique entre les deux parties pour le cas où l'une d'entre elles dissipe une vingtaine de Watts.

Le nombre et/ou la forme des cartes électroniques pourra être différent de ce qui a été indiqué.

Le nombre et/ou la forme des pattes pourra être différent de ce qui a été indiqué.

Le nombre et/ou la forme des ailettes pourra être différent de ce qui a été indiqué. Au moins une des ailettes principales pourra être en contact avec une patte sur une première de ses faces principales et avec une autre patte (ou la même) sur la deuxième de ses faces principales comme représenté à la figure 8.

Bien qu'ici au moins une ailette principale soit munie d'un revêtement supplémentaire pour assurer un bon contact électrique, l'ailette principale pourra au contraire présenter une zone avec un revêtement moindre que les zones adjacentes pour assurer un contact électrique fiable (par exemple on pourra créer cette zone spécifique par grattage, polissage, épargne, ou tout autre procédé). Typiquement, dans le cas d'ailette principale en aluminium, il sera envisageable d'avoir une telle zone ainsi exempte d'oxyde d'alumine, isolant électrique naturel. Alternativement, au moins l'une des ailettes principales pourra être munie d'un dispositif spécifique pour assurer le bon contact électrique avec la patte en regard. Le dispositif pourra ainsi être par exemple une pièce métallique fixée à l'ailette principale. Cette pièce pourra être attachée par rivetage, bouterole, soudage, ou tout autre moyen.

Le nombre et la répartition des connecteurs entre les deux parties du caisson sera de préférence défini pour assurer une équipotentialité adaptée à la performance du boitier. Par exemple pour assurer une équipotentialité correcte entre deux cartes électronique mettant en œuvre des signaux rapides de type PCIe (pour « Peripheral Component Interconnect Express » en anglais) routés sur l'une ou l'autre des cartes électroniques, on préférera assurer un point de contact pour 12 centimètres carrés et par exemple pour 10 centimètres carrés d'une face principale associée à la première carte électronique (par exemple celle d'un dissipateur thermique) et de manière correspondante d'une face principale en regard associée à la deuxième carte électronique (par exemple celle d'un organe de connexion).

L'organe de connexion pourra lui-même être un dissipateur thermique, les connecteurs de la deuxième partie étant alors des ailettes principales ou présentant une tout autre forme assurant au moins le contact électrique avec les connecteurs de l'autre partie en regard. La deuxième partie pourra comporter un dissipateur thermique en plus de son organe de connexion.

De manière correspondante la première partie pourra comprendre un organe de connexion en place d'un dissipateur thermique, les connecteurs de la première partie étant alors des pattes ou présentant une tout autre forme assurant au moins le contact électrique avec les connecteurs de l'autre partie en regard. La première partie pourra comporter un organe de connexion en plus de son dissipateur thermique. Les connecteurs en regard pourront ne pas être des couples ailettes/pattes mais être conformés différemment.

Le dissipateur thermique et/ou l'organe de connexion pourront faire partie intégrante de la carte électronique associée.

Le dissipateur thermique pourra ne comporter que des ailettes principales. Le dissipateur thermique pourra comporter des ailettes (principales ou non) sur ses deux faces principales. Bien qu'ici le tronçon de la première partie et celui de la deuxième partie soit de la même longueur (selon le troisième axe X), l'un des tronçons pourra être d'une longueur plus importante que l'autre. Une seule partie pourra comporter l'intégralité du conduit qui viendra alors directement s'encastrer dans l'autre partie correspondante.

Le caisson pourra n'avoir qu'un seul conduit qui définira alors de part et d'autre deux canaux de circulation d'air semi-ouverte sur l'extérieur.

Le caisson pourra ne pas être dans un matériau thermiquement isolant ou pourra ne pas être entièrement dans un matériau électriquement isolant. Le caisson pourra ainsi être au moins en partie par exemple en matériau à base de ou en métal ce qui facilitera l'évacuation des calories hors du caisson.

## Revendications

1. Boitier électronique (1) comprenant un caisson (2) comportant au moins une première partie (3) et au moins une deuxième partie (4), chaque partie formant un réceptacle distinct de sorte qu'une première carte électronique (13) soit logée dans la première partie et de sorte qu'une deuxième carte électronique (14) soit logée dans la deuxième partie, les deux parties étant solidarisées l'une à l'autre par au moins un conduit (6), le boitier comprenant au moins un premier connecteur (17) lié à la première carte électronique et au moins un deuxième connecteur (22) lié à la deuxième carte électronique, les deux connecteurs étant en contact l'un l'autre à travers l'intérieur du conduit, au moins une zone du premier connecteur en contact avec le deuxième connecteur étant dans un matériau électriquement conducteur et au moins une zone du deuxième connecteur en contact avec le premier connecteur étant dans un matériau électriquement conducteur, l'extérieur du conduit étant par ailleurs conformé pour définir au moins partiellement un canal (8, 9, 10, 11) de circulation d'air entre les deux parties du caisson (2), le boitier comprenant au moins un dissipateur (15) thermique associé à une des deux cartes électroniques, le dissipateur thermique portant le connecteur de la partie correspondante.

2. Boitier selon la revendication 1, dans lequel le canal (8, 9, 10, 11) de circulation d'air entre les deux parties du caisson (2) s'étend le long d'une première face de la première partie (3) et le long d'une deuxième face de la deuxième partie (4), les deux parties étant en regard l'une de l'autre.

3. Boitier selon la revendication 2, dans lequel la première face et la deuxième face sont sensiblement parallèles entre elles.

4. Boitier selon la revendication 2 ou la revendication 3, dans lequel au moins l'un des deux cartes électroniques (13, 14) s'étend sensiblement parallèlement à la première face et/ou à la deuxième face.

5. Boitier selon l'une des revendications précédentes, dans lequel le canal est fermé mis à part à ses extrémités axiales.

6. Boitier selon l'une des revendications précédentes, dans lequel le conduit est formé par deux tronçons de conduits (6) comportant des moyens de raccordement d'un tronçon à l'autre.

7. Boitier selon l'une des revendications précédentes, dans lequel le connecteur (17) est une ailette du dissipateur (15).

8. Boitier selon l'une des revendications précédentes, comprenant au moins un organe de connexion (18) associé à une des deux cartes électroniques, l'organe de connexion portant le connecteur de la partie correspondante.

9. Boitier selon l'une des revendications précédentes, dans lequel au moins un connecteur (22) est conformé en une patte.

10. Boitier selon l'une des revendications précédentes, dans lequel au moins un des connecteurs (22) est au moins en partie élastiquement déformable.

11. Boitier selon l'une des revendications précédentes, dans lequel un des connecteurs (22) est en contact avec un côté latéral de l'autre connecteur.

12. Boitier selon l'une des revendications précédentes, dans lequel les deux connecteurs (17,22) sont fixés temporairement l'un à l'autre.

13. Boitier selon l'une des revendications précédentes, dans lequel au moins un des connecteurs (17) s'étend sur toute la largeur du conduit associé.

14. Boitier selon l'une des revendications précédentes, dans lequel le boitier (1) est une passerelle Internet.

15. Boitier selon l'une des revendications précédentes, dans lequel le boitier (1) est un dispositif d'extension de réseau sans-fil.

## Patentansprüche

1. Elektronisches Gehäuse (1), welches einen Korpus (2) mit zumindest einem ersten Teil (3) und zumindest einem zweiten Teil (4) umfasst, wobei jeder Teil einen separaten Aufnahmeraum bildet, sodass eine erste Elektronikkarte (13) in dem ersten Teil untergebracht ist und eine zweite Elektronikkarte (14) in dem zweiten Teil untergebracht ist, wobei die beiden Teile durch zumindest eine Durchführung (6) hindurch fest miteinander verbunden sind, wobei das Gehäuse zumindest einen ersten, mit der ersten Elektronikkarte verbundenen Verbinder (17) und zumindest einen zweiten, mit der zweiten Elektronikkarte verbundenen Verbinder (22) umfasst, wobei die beiden Verbinder durch das Innere der Durchführung hindurch miteinander in Kontakt stehen, wobei zumindest ein Bereich des ersten Verbinders, der mit dem zweiten Verbinder in Kontakt steht, aus einem elektrisch leitenden Material besteht und zumindest ein Bereich des zweiten Verbinders, der mit dem ersten Verbinder in Kontakt steht, aus einem elektrisch leitenden Material besteht, wobei das Äußere der Durchführung im Übrigen derart ausgebildet ist, dass es zumindest teilweise einen Kanal (8, 9, 10, 11) definiert, welcher der Luftzirkulation zwischen den beiden Teilen des Korpus (2) dient, wobei das Gehäuse zumindest einen Kühlkörper (15) umfasst, der mit einer der beiden Elektronikkarten verbunden ist, wobei der Kühlkörper den Verbinder des entsprechenden Teils trägt.

2. Gehäuse nach Anspruch 1, wobei sich der Luftzirkulationskanal (8, 9, 10, 11) zur Luftzirkulation zwischen den beiden Teilen des Korpus (2) entlang einer ersten Seite des ersten Teils (3) und entlang einer zweiten Seite des zweiten Teils (4) erstreckt, wobei die beiden Teile einander gegenüberüberliegend angeordnet sind.

3. Gehäuse nach Anspruch 2, wobei die erste Seite und die zweite Seite im Wesentlichen parallel zueinander angeordnet sind.

4. Gehäuse nach Anspruch 2 oder nach Anspruch 3, wobei sich zumindest eine der beiden Elektronikkarten (13, 14) im Wesentlichen parallel zu der ersten Seite und/oder zu der zweiten Seite erstreckt.

5. Gehäuse nach einem der vorhergehenden Ansprüche, wobei der Kanal abgesehen von seinen axialen Enden geschlossen ist.

6. Gehäuse nach einem der vorhergehenden Ansprüche, wobei die Durchführung aus zwei Durchführungsabschnitten (6) gebildet ist, welche Verbindungsmittel zum Verbinden eines Durchführungsabschnitts mit dem anderen enthalten.

7. Gehäuse nach einem der vorhergehenden Ansprüche, wobei es sich bei dem Verbinder (17) um eine Rippe des Kühlkörpers (15) handelt.

8. Gehäuse nach einem der vorhergehenden Ansprüche, umfassend zumindest ein Anschlussorgan (18), das mit einer der beiden Elektronikkarten verbunden ist, wobei das Anschlussorgan den Verbinder des entsprechenden Teils trägt.

9. Gehäuse nach einem der vorhergehenden Ansprüche, wobei zumindest ein Verbinder (22) als Lasche ausgebildet ist.

10. Gehäuse nach einem der vorhergehenden Ansprüche, wobei zumindest einer der Verbinder (22) zumindest teilweise elastisch verformbar ist.

11. Gehäuse nach einem der vorhergehenden Ansprüche, wobei einer der Verbinder (22) in Kontakt mit einer lateralen Seite des anderen Verbinders steht.

12. Gehäuse nach einem der vorhergehenden Ansprüche, wobei die beiden Verbinder (17, 22) temporär aneinander befestigt sind.

13. Gehäuse nach einem der vorhergehenden Ansprüche, wobei sich zumindest einer der Verbinder (17) über die gesamte Breite der ihm zugeordneten Durchführung erstreckt.

14. Gehäuse nach einem der vorhergehenden Ansprüche, wobei es sich bei dem Gehäuse (1) um ein Internet-Gateway handelt.

15. Gehäuse nach einem der vorhergehenden Ansprüche, wobei es sich bei dem Gehäuse (1) um eine Drahtlos-Netzwerkerweiterungsvorrichtung handelt.

## Claims

1. Electronic casing (1) comprising a box (2) comprising at least one first part (3) and at least one second part (4), each part forming a distinct container, such that a first electronic board (13) is housed in the first part and such that a second electronic board (14) is housed in the second part, the two parts being integral with one another by at least one conduit (6), the casing comprising at least one first connector (17) linked to the first electronic board and at least one second connector (22) linked to the second electronic board, the two connectors being in contact with one another through the inside of the conduit, at least one zone of the first connector in contact with the second connector being made of an electrically conductive material and at least one zone of the second connector in contact with the first connector being made of an electrically conductive material, the outside of the conduit being moreover shaped to define at least partially an air circulation channel (8, 9, 10, 11) between the two parts of the box (2), the casing comprising at least one heat dissipater (15) associated with one of the two electronic boards, the heat dissipater carrying the connector of the corresponding part.

2. Casing according to claim 1, wherein the air circulation channel (8, 9, 10, 11) between the two parts of the box (2) extends along a first face of the first part (3) and along a second face of the second part (4), the two parts facing one another.

3. Casing according to claim 2, wherein the first face and the second face are substantially parallel to one another.

4. Casing according to claim 2 or claim 3, wherein at least one of the two electronic boards (13, 14) extends substantially parallel to the first face and/or to the second face.

5. Casing according to one of the preceding claims, wherein the channel is closed, apart from its axial ends.

6. Casing according to one of the preceding claims, wherein the conduit is formed by two conduit sections (6) comprising means for connecting from one section to another.

7. Casing according to one of the preceding claims, wherein the connector (17) is a vane of the dissipater (15).

8. Casing according to one of the preceding claims, comprising at least one connecting member (18) associated with one of the two electronic boards, the connecting member carrying the connector of the corresponding part.

9. Casing according to one of the preceding claims, wherein at least one connector (22) is tab-shaped.

10. Casing according to one of the preceding claims, wherein at least one of the connectors (22) is at least partially elastically deformable.

11. Casing according to one of the preceding claims, wherein one of the connectors (22) is in contact with a lateral side of the other connector.

12. Casing according to one of the preceding claims, wherein the two connectors (17, 22) are temporarily fixed to one another.

13. Casing according to one of the preceding claims, wherein at least one of the connectors (17) extends over the entire width of the associated conduit.

14. Casing according to one of the preceding claims, wherein the casing (1) is a residential gateway.

15. Casing according to one of the preceding claims, wherein the casing (1) is a wireless network extension device.
